# EUROPÄISCHE PATENTANMELDUNG

(11) **EP 0 741 454 A1**
(43) Veröffentlichungstag der Anmeldung: **06.11.1996**
(21) Anmeldenummer: 96107364.0
(22) Anmeldetag: 04.05.1995
(51) Int. Cl.: H03K 19/00, H03K 19/173, H03K 19/003

(54) **Integrierte Schaltung**

(71) Anmelder: SIEMENS AKTIENGESELLSCHAFT, 80333 München (DE)
(72) Erfinder: Stecker, Johannes, Dr. rer. nat., 80992 München (DE); Kristofferson, Thomas, 81667 München (DE); Chrysostomides, Ioannis, 81927 München (DE)

(57) **Zusammenfassung**

Integrierte Schaltung mit Grundschaltungen (1), die die Funktion der integrierten Schaltung (10) bei einem ersten Wert einer Versorgungsspannung (U) gewährleisten. Die integrierte Schaltung (10) weist ferner Zusatzschaltungen (3) auf, die mit einem Teil der Grundschaltungen (1) verbunden sind. Sie sind aktivierbar und beeinflussen dann die Funktion der entsprechenden Grundschaltungen (1) in der Weise, daß die integrierte Schaltung (10) auch bei einem zweiten Wert der Versorgungsspannung (U) ordnungsgemäß funktioniert. Eine der Grundschaltungen (1) weisteinen ersten Transistor (T1) auf, der eine Konstantstromquelle ist. Die mit der Grundschaltung (1) verbundene Zusatzschaltung (3) weist einen zweiten Transistor (T2) vom gleichen Kanaltyp wie der erste Transistor (T1) auf, welcher parallel zum ersten Transistor (T1) schaltbar ist.

## Beschreibung

Die Erfindung betrifft eine integrierte Schaltung gemäß dem Oberbegriff des Anspruchs 1.

Eine gattungsgemäße Schaltung ist aus C. McClintock et al.: "A low power programmable logic device reconfigurable for 3.3 V or 5.0 V Operation during and after fabrication", in: Proceedings of the IEEE 1994 Custom Integrated Circuits Conference -- CICC '94, Mai 1994, Seiten 177-180 bekannt. Dort ist die Anpassung einer TTL-Eingangspufferschaltung, die als CMOS-Inverter realisiert ist, an den Betrieb mit wahlweise 3,3 V oder 5 V beschrieben. Zu diesem Zwecke wird dem n-Kanal-Transistor des CMOS-Inverters beim Betrieb mit einer der beiden Versorgungsspannungen ein weiterer n-Kanal-Transistor parallel geschaltet.

Es besteht Bedarf sowohl nach integrierten Schaltungen, welche mit einem ersten Wert einer Versorgungsspannung, beispielsweise 5 V, versorgbar sind als auch nach integrierten Schaltungen, die zwar dieselben Funktionen erfüllen wie die erstgenannten integrierten Schaltungen, jedoch mit einem zweiten Wert der Versorgungsspannung, beispielsweise 3,3 V, betreibbar sind. Für Hersteller von integrierten Schaltungen wäre es günstig, nur einen Typ einer solchen integrierten Schaltung für den Betrieb mit beiden Werten der Versorgungsspannung herstellen zu müssen.

Werden integrierte Schaltungen, die zum Betrieb mit einem ersten Wert einer Versorgungsspannung ausgelegt sind, mit einem zweiten Wert der Versorgungsspannung betrieben, funktionieren sie häufig nicht ordnungsgemäß. Dies liegt daran, daß sie für den Betrieb mit dem ersten Wert der Versorgungsspannung optimiert sind, so daß sich beim Betrieb mit diesem ersten Wert der Versorgungsspannung gewünschte Signallaufzeiten, Schaltzeiten, Schaltpegel usw. ergeben. Eine solchermaßen optimierte Schaltung ist in der Regel nicht auch für den Betrieb mit dem zweiten Wert der Versorgungsspannung optimiert, so daß sie bei diesem nicht ordnungsgemäß funktioniert.

Es ist bekannt, integrierte Schaltungen intern ausschließlich mit einer niedrigen Versorgungsspannung von 3,3 V zu betreiben, wobei extern aber eine Versorgungsspannung von wahlweise 5 V oder 3,3 V anlegbar ist. Im Falle der höheren externen Versorgungsspannung erfolgt innerhalb der integrierten Schaltung eine Herabsetzung auf die erforderlichen 3,3 V. Nachteilig ist hierbei zum einen, daß eine entsprechende Spannungsreglerschaltung vorgesehen werden muß, die zusätzliche Layoutfläche beansprucht. Zum anderen kann es notwendig sein, daß eine solche integrierte Schaltung bei Betrieb mit einer externen Versorgungsspannung von 5 V auch Ausgangssignale mit 5V-Pegel liefert, was beim geschilderten Stand der Technik nur mit sehr großem Aufwand realisierbar ist.

Neben dem oben genannten Stand der Technik (Mcclintock et al.) sind auch integrierte Schaltungen mit einer Eingangspufferschaltung bekannt, die eine Konstantstromquelle aufweist.

Der Erfindung liegt die Aufgabe zugrunde, eine integrierte Schaltung mit einer Eingangspufferschaltung, die eine Konstantstromquelle enthält, zu schaffen, welche sowohl mit einem ersten Wert einer Versorgungsspannung als auch mit einem zweiten Wert der Versorgungsspannung ordnungsgemäß funktioniert.

Gelöst wird diese Aufgabe durch eine integrierte Schaltung mit den Merkmalen des Anspruchs 1. Weiterbildungen der Erfindung sind in den Unteransprüchen gekennzeichnet.

Integrierte Schaltungen weisen in der Regel eine Vielzahl von Grundschaltungen auf, welche Teilfunktionen der integrierten Schaltung ausführen. Jede dieser Grundschaltungen ist mit wenigstens einer der anderen Grundschaltungen und/oder mit der Umgebung der integrierten Schaltung verbunden. Auf diese Weise gewährleisten die Grundschaltungen durch ihr Zusammenwirken die ordnungsgemäße (also optimierte) Funktion der gesamten integrierten Schaltung bei einem ersten Wert der Versorgungsspannung.

Die vorgesehenen Zusatzschaltungen sind so gestaltet, daß sie die Funktion der mit ihnen verbundenen Grundschaltungen in der Weise beeinflussen, daß die gesamte integrierte Schaltung auch beim zweiten Wert der Versorgungsspannung ordnungsgemäß funktioniert. Dabei kann es ausreichen, wenn nur ein Teil der Grundschaltungen mit einer Zusatzschaltung verbunden ist, da andere der Grundschaltungen bei beiden Werten der Versorgungsspannung zu einer ordnungsgemäßen Funktion der gesamten integrierten Schaltung beitragen. Die Zusatzschaltungen 3 können beispielsweise dazu dienen, die Einhaltung verschiedener Spezifikationen bei unterschiedlichen Werten der Versorgungsspannung zu gewährleisten.

Die Erfindung bietet den Vorteil, daß bestehende Schaltungen nur geringfügig zu verändern sind, um sie mit verschiedenen Werten der Versorgungsspannung betreiben zu können. Die bestehenden Schaltungen müssen lediglich um die notwendigen Zusatzschaltungen ergänzt werden. Da diese aus nur wenigen Komponenten bestehen, ergibt sich nur ein geringer Platzaufwand für die zusätzlichen Schaltungskomponenten.

Vorteilhaft ist ferner, daß für einen internen Betrieb mit einer extern angelegten Versorgungsspannung von 5 V anstelle einer herabgesetzten Versorgungsspannung ein geringer schaltungstechnischer Aufwand notwendig ist, um kleine Schaltzeiten und ausreichend hohe Ausgangspegel zu realisieren.

Da die integrierte Schaltung intern mit der extern angelegten Versorgungsspannung betrieben wird, ist kein Spannungsregler erforderlich und die Ausgangssignale der integrierten Schaltung haben den gleichen Pegel wie die Versorgungsspannung.

Zur Realisierung des wahlweisen Betriebs der integrierten Schaltung bei beiden Werten der Versorgungsspannung kann das Aktivierungssignal beispielsweise über einen externen Anschluß der integrierten Schaltung zugeführt werden. Es ist auch möglich, eine Programmierfunktion der integrierten Schaltung vorzusehen, welche die Erzeugung des Aktivierungssignals ermöglicht.

In einer Anwendung eines anderen Ausführungsbeispiels der erfindungsgemäßen integrierten Schaltung kann das Aktivierungssignal gegen Ende ihres Herstellprozesses permanent auf ein Potential festgelegt werden. Dies kann beispielsweise durch Öffnen einer Fuse oder durch Anbringen eines Bonddrahtes geschehen. Auf diese Weise kann zu einem späten Zeitpunkt des Produktionsablaufes festgelegt werden, für welchen Wert der Versorgungsspannung die integrierte Schaltung einsetzbar ist. Das Layout, die Herstellmasken und der gesamte Produktionsprozeß sind dabei für beide Typen der integrierten Schaltung gleich. Dies bietet den Vorteil, daß die Notwendigkeit einer Festlegung des Wertes der Versorgungsspannung nach Abschluß des Herstellprozesses entfällt und somit zusätzliche Anschlüsse zur Zuführung des Aktivierungssignals oder eine zusätzliche Programmierfunktion nicht notwendig sind.

Ausführungsbeispiele der Erfindung werden anhand der Zeichnung erläutert. Es zeigen:
- Figur 1: ein Prinzipschaltbild der erfindungsgemäßen integrierten Schaltung,
- Figur 6 und 7: Ausführungsbeispiele der erfindungsgemäßen integrierten Schaltung aus Figur 1,

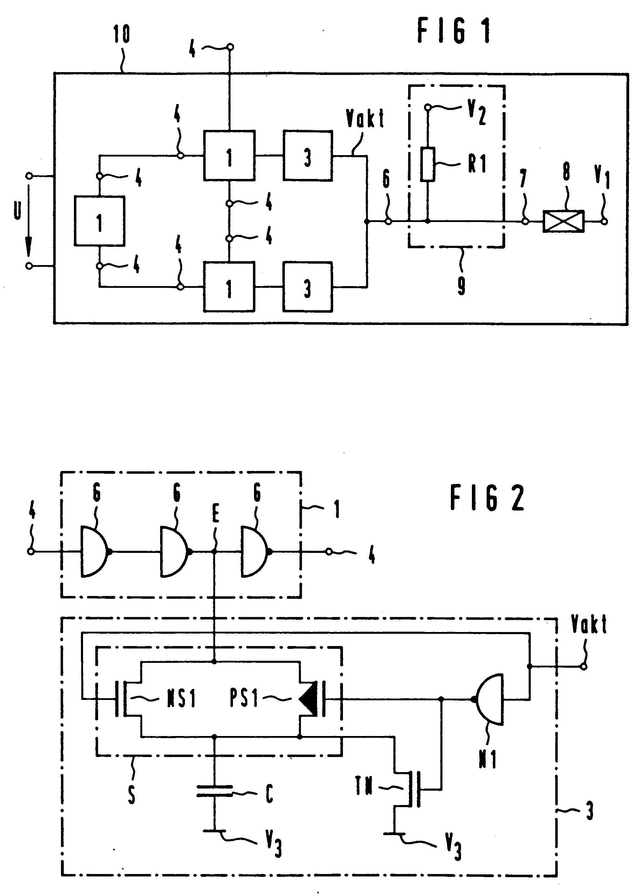

- Figuren 2-5, 8: weitere integrierte Schaltungen.

Figur 1 zeigt ein Ausführungsbeispiel der erfindungsgemäßen integrierten Schaltung 10, an welche eine Versorgungsspannung U anlegbar ist. Sie weist Grundschaltungen 1 auf, von denen jede über Anschlüsse 4 mit anderen Grundschaltungen 1 verbunden ist oder mit externen Schaltungen außerhalb der integrierten Schaltung 10 verbindbar ist.

Es wird nun angenommen, daß die integrierte Schaltung 10 bei einem ersten Wert der Versorgungsspannung U, beispielsweise 5 V, mittels der Grundschaltungen 1 ordnungsgemäß funktioniert. Damit eine ordnungsgemäße Funktion der integrierten Schaltung 10 auch bei einem zweiten Wert der Versorgungsspannung U, beispielsweise 3,3 V, ordnungsgemäß erfolgen kann, weist sie Zusatzschaltungen 3 auf, von denen bei diesem Ausführungsbeispiel jede mit einer der Grundschaltungen 1 verbunden ist. Die Zusatzschaltungen 3 haben die Aufgabe, beim zweiten Wert der Versorgungsspannung U die Funktion der mit ihnen verbundenen Grundschaltungen 1 in der Weise zu beeinflussen, daß die gesamte integrierte Schaltung 10 ordnungsgemäß funktioniert.

Die Zusatzschaltungen 3 sind aktivierbar und deaktivierbar, damit sie im deaktivierten Zustand keinen Einfluß auf die Funktion der Grundschaltungen 1 ausüben. Die integrierte Schaltung 10 funktioniert dann beim ersten Wert der Versorgungsspannung U ordnungsgemäß. Werden die Zusatzschaltungen 3 jedoch aktiviert, beeinflussen sie die Funktion der Grundschaltungen 1 in der Weise, daß die integrierte Schaltung 10 beim zweiten Wert der Versorgungsspannung U ordnungsgemäß funktioniert.

Die Aktivierung bzw. Deaktivierung der Zusatzschaltungen 3 erfolgt über ein Aktivierungssignal Vakt, welches bei diesem Ausführungsbeispiel der Erfindung durch einen Aktivierungssignal-Generator 9 erzeugt wird. Der Aktivierungssignal-Generator 9 erzeugt an seinem Ausgang 6 das Aktivierungssignal Vakt in Abhängigkeit davon, welches Potential an einem Eingang 7 anliegt. Der Eingang 7 ist über ein Verbindungselement 8 mit einem ersten Potential V1 verbindbar. Wird diese Verbindung hergestellt, nimmt das Aktivierungssignal Vakt einen ersten Zustand an. Das Aktivierungssignal Vakt nimmt einen zweiten Zustand an, wenn der Eingang 7 nicht mit dem ersten Potential V1 verbunden ist.

Bei diesem Ausführungsbeispiel ist der Aktivierungssignal-Generator 9 folgendermaßen realisiert: Sein Eingang 6 und Ausgang 7 sind miteinander und außerdem über ein erstes Widerstandselement R1 mit einem zweiten Potential V2 verbunden. Ist das erste Verbindungselement 8 vorhanden, ist das Aktivierungssignal Vakt annähernd gleich dem ersten Potential V1. Ist das Verbindungselement 8 nicht vorhanden, ist das Aktivierungssignal Vakt gleich dem zweiten Potential V2.

Das Verbindungselement 8 kann beispielsweise eine Fuse oder ein Bonddraht sein. In diesen beiden Fällen muß allerdings bereits während des Herstellungsprozesses der integrierten Schaltung 10 entschieden werden, bei welchem Wert der Versorgungsspannung U diese betrieben werden soll. Bevor diese Entscheidung getroffen worden ist und der entsprechende Herstellschritt ausgeführt wurde, besteht noch die erfindungsgemäße Wahlmöglichkeit, bei welchem Wert der Versorgungsspannung U die integrierte Schaltung einsetzbar sein soll. Bei diesem Ausführungsbeispiel kann diese Wahl aber nur einmal getroffen werden.

Statt das Aktivierungssignal Vakt mit dem Aktivierungssignal-Generator 9 zu erzeugen (Figur 1), ist es auch möglich, es über einen externen Anschluß der integrierten Schaltung 10 zuzuführen. Dann ist die integrierte Schaltung 10 nach ihrer Herstellung wahlweise beim ersten oder beim zweiten Wert der Versorgungsspannung U betreibbar.

Die integrierte Schaltung 10 in Figur 1 enthält drei Grundschaltungen 1, von denen nur zwei mit je einer Zusatzschaltung 3 verbunden sind. Bei diesem Ausführungsbeispiel wird nämlich angenommen, daß die mit keiner Zusatzschaltung 3 verbundene Grundschaltung 1 bei beiden Werten der Versorgungsspannung U in der Weise funktioniert, daß die ordnungsgemäße Funktion der integrierten Schaltung 10 durch sie nicht beeinträchtigt wird. Derartige Grundschaltungen 1 können beispielsweise Schaltungen sein, die logische Verknüpfungen realisieren.

Die mit einer Zusatzschaltung 3 verbundenen Grundschaltungen 1 sind dagegen solche, deren Komponenten für den ersten Wert der Versorgungsspannung U optimiert sind, beim zweiten Wert der Versorgungsspannung U jedoch eine ungeeignete Dimensionierung aufweisen, so daß diese Grundschaltungen 1 beim zweiten Wert der Versorgungsspannung U ohne Beeinflussung durch die Zusatzschaltungen 3 die ordnungsgemäße Funktion der integrierten Schaltung 10 nicht zulassen.

Die von den Grundschaltungen 1 ausgeübten und von den Zusatzschaltungen 3 zu beeinflussenden Funktionen sind insbesondere solche, bei denen Schaltpegel oder Schaltzeiten, die vom Wert der Versorgungsspannung U abhängig sind, eine Rolle spielen.

Im folgenden werden anhand der Figuren 2 bis 6 Ausführungsbeispiele der Grundschaltungen 1 sowie der entsprechenden Zusatzschaltungen 3 beschrieben.

Figur 2 zeigt eine der Grundschaltungen 1, welche eine Verzögerungsschaltung ist. Sie weist eine Reihenschaltung aus logischen Gattern G auf, deren Gatterlaufzeit die Verzögerungszeit der Verzögerungsschaltung beeinflussen. Die Reihenschaltung ist eingangs- und ausgangsseitig mit je einem der Anschlüsse 4 verbunden. Die Gatter G können, wie in Figur 2 dargestellt, Inverter sein, es kommen aber auch andere Gatterarten in Betracht.

Die mit der Grundschaltung 1 verbundene Zusatzschaltung 3 weist eine Reihenschaltung aus einem Schalter S und einem Kondensator C auf. Ein Eingang E eines der Gatter G ist über den Schalter S mit dem Kondensator C verbunden. Der Kondensator C ist mit seinem anderen Anschluß mit einem dritten Potential V3, welches bei diesem Ausführungsbeispiel Masse ist, verbunden. Der Schalter S ist durch das Aktivierungssignal Vakt steuerbar.

Bei diesem Ausführungsbeispiel ist der Schalter S durch zwei parallel geschaltete Schalttransistoren NS1, PS1 von gegensätzlichem Leitungstyp realisiert. Das Aktivierungssignal Vakt ist mit dem Gate des N-Kanal-Schalttransistors NS1 und über einen Inverter N1 mit dem Gate des P-Kanal-Schalttransistors PS1 verbunden. Zur Entladung des Kondensators C bei geöffnetem Schalter S ist zusätzlich parallel zum Kondensator C ein N-Kanaltransistor TN vorgesehen, dessen Gate mit dem Gate des P-Kanal-Schalttransistors PS1 verbunden ist.

Wird die Zusatzschaltung 3 über das Aktivierungssignal Vakt aktiviert, wird der Schalter S geschlossen und der Kondensator C bildet eine zusätzliche kapazitive Last am Eingang E des Gatters G. Dadurch erhöht sich die Gatterlaufzeit dieses Gatters G und damit auch die Verzögerungszeit der Grundschaltung 1.

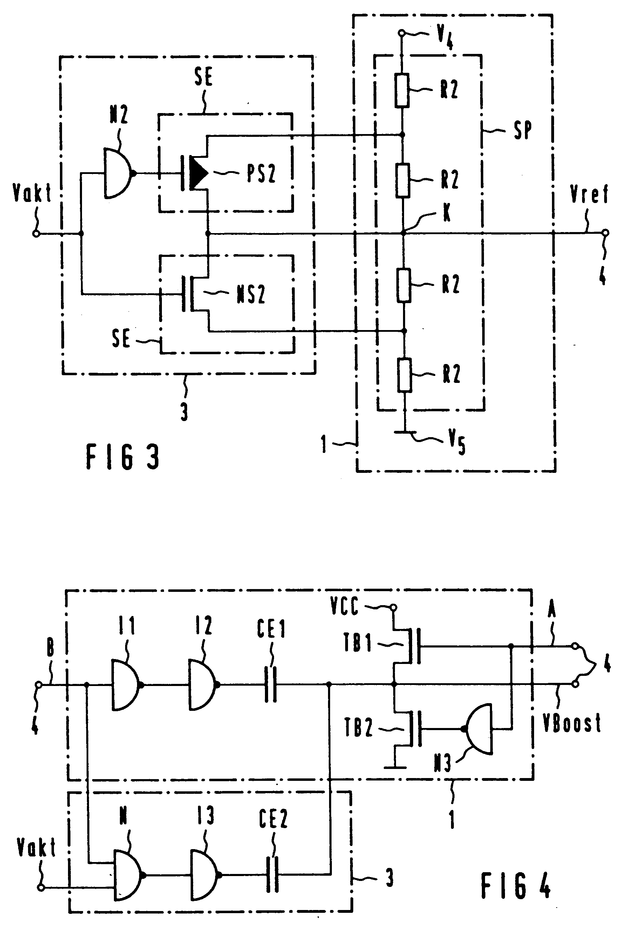

Beim Ausführungsbeispiel nach Figur 3 weist die Grundschaltung 1 einen Spannungsteiler SP auf, welcher zwischen einem vierten V4 und einem fünften V5 Potential angeordnet ist und in einer Reihenschaltung vier zweite Widerstandselemente R2 beinhaltet, wobei die Widerstandselemente R2 unterschiedliche Werte aufweisen können. Sie können beispielsweise als ohmsche Widerstände oder als als Widerstände verbundene Transistoren ausgeführt sein. Es wird angenommen, daß das vierte Potential V4 größer als das fünfte Potential V5 ist. Letzteres kann beispielsweise wiederum Masse sein, wie in Figur 3 dargestellt. Es wird unterstellt, daß die Spannung zwischen dem vierten Potential V4 und dem fünften Potential V5 sich ändert, sofern ein anderer Wert der Versorgungsspannung U gewählt wird. In der Mitte des Spannungsteilers SP entsteht an einem Schaltungsknoten K ein Referenzpotential Vref, welches über einen der Anschlüsse 4 anderen Grundschaltungen 1 oder der Umgebung der integrierten Schaltung 10 zuführbar ist.

Um beim zweiten Wert der Versorgungsspannung U das Spannungsteilerverhältnis zu ändern und damit den Wert des Referenzpotentials Vref zu beeinflussen, weist die mit der Grundschaltung 1 verbundene Zusatzschaltung 3 zwei Schalterelemente SE auf, nämlich einen P-Kanal-Schalttransistor PS2 und einen N-Kanal-Schalttransistor NS2. Der P-Kanal-Schalttransistor PS2 überbrückt im durchgeschalteten Zustand dasjenige zweite Widerstandselement R2, welches mit dem Schaltungsknoten K verbunden und in Richtung des vierten Potentials V4 angeordnet ist. Der N-Kanal-Schalttransistor NS2 überbrückt im durchgeschalteten Zustand dasjenige zweite Widerstandselement R2, welches mit dem Schaltungsknoten K verbunden und in Richtung des fünften Potentials V5 angeordnet ist. Die beiden Schalttransistoren PS2, NS2 werden äquivalent zu den Schalttransistoren PS1, NS1 in Figur 2 über das Aktivierungssignal Vakt angesteuert.

Wird die Zusatzschaltung 3 aktiviert und damit die Schalterelemente SE durchgeschaltet, werden die beiden mittleren zweiten Widerstandselemente R2 jeweils überbrückt, so daß sich das Spannungsteilerverhältnis des Spannungsteilers SP dann nur noch durch die beiden äußeren zweiten Widerstandselemente R2 ergibt.

Bei dem Ausführungsbeispiel in Figur 4 ist die Grundschaltung 1 eine an sich bekannte Spannungsüberhöhungsschaltung. Einer der Anschlüsse 4, an welchem eine Boostspannung VBoost erzeugt werden soll, ist über einen ersten Boosttransistor TB1 vom N-Kanaltyp mit einem Versorgungspotential VCC und über einen zweiten Boosttransistor T2 vom N-Kanaltyp mit Masse verbunden. Es wird angenommen, daß das Versorgungspotential VCC für verschiedene Werte des Versorgungspotentials U verschiedene Werte annimmt. Die beiden Boosttransistoren TB1, TB2 werden über ein erstes Steuersignal A, welches an einen anderen der Anschlüsse 4 anlegbar ist, gesteuert. Dazu ist dieser Anschluß 4 mit dem Gate des ersten Boosttransistors TB1 und über einen Inverter N3 mit dem Gate des zweiten Boosttransistors TB2 verbunden. Ein weiterer der Anschlüsse 4, an welchen ein zweites Steuersignal B anlegbar ist, ist über einen ersten I1 und einen zweiten I2 Inverter und ein erstes Kondensatorelement CE1 mit demjenigen der Anschlüsse 4 verbunden, an welchem die Boostspannung VBoost erzeugt werden soll.

Zur Erzeugung der Boostspannung VBoost wird nun in bekannter Weise der entsprechende Anschluß 4 mittels des Steuersignals A auf etwa das Versorgungspotential VCC vorgeladen. Anschließend wird mittels des zweiten Steuersignals B das Potential des ersten Kondensatorelements C1 verschoben, so daß die gewünschte Spannungsüberhöhung erreicht wird.

Die mit der Grundschaltung 1 verbundene Zusatzschaltung 3 weist ein zweites Kondensatorelement CE2 auf, welches mittels des Aktivierungssignals Vakt parallel zum ersten Kondensatorelement CE1 schaltbar ist. Das zweite Kondensatorelement CE2 ist dazu einerseits mit dem Anschluß 4, an dem die Boostspannung VBoost erzeugt werden soll, verbunden und andererseits mit dem Ausgang eines dritten Inverters I3, der einem NAND-Gatter N nachgeschaltet ist. Einem Eingang des NAND-Gatters N ist das zweite Steuersignal B zuführbar. Ein anderer Eingang des NAND-Gatters N ist mit dem Aktivierungssignal Vakt verbunden.

Wird beim zweiten Wert der Versorgungsspannung U die Zusatzschaltung 3 mittels des Aktivierungssignals Vakt aktiviert, ergibt sich durch Parallelschaltung der beiden Kondensatorelemente CE1, CE2 eine größere Überhöhung der Boostspannung VBoost als bei deaktivierter Zusatzschaltung 3.

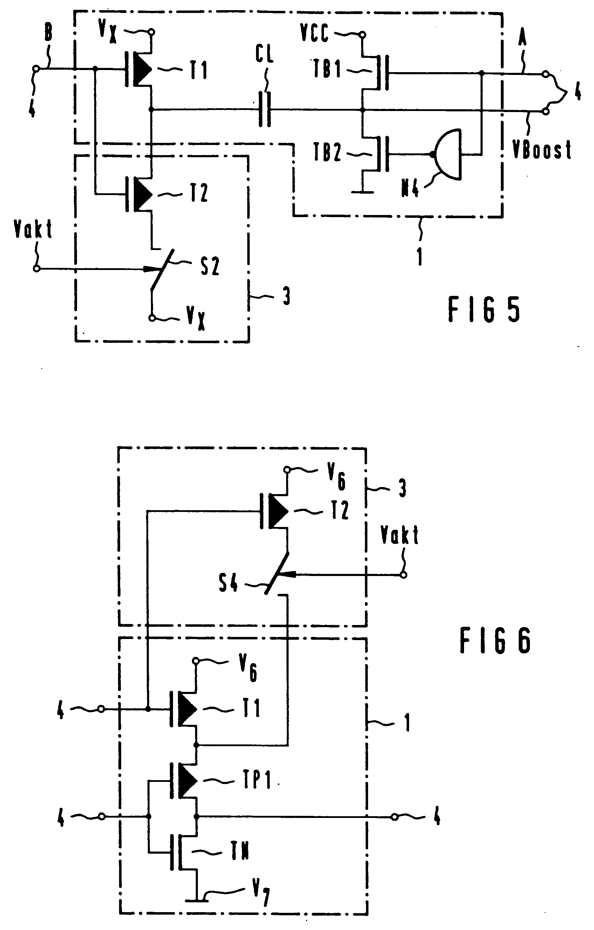

Figur 5 zeigt als Grundschaltung 1 wiederum eine Spannungsüberhöhungsschaltung, die zur Spannungsüberhöhung einen Ladekondensator CL aufweist. Die Grundschaltung 1 in Figur 5 unterscheidet sich von der in Figur 4 hinsichtlich der Zuführung des zweiten Steuersignals B über einen der Anschlüsse 4. Dieser ist mit dem Gate eines ersten Transfertransistors T1 verbunden, welcher im durchgeschalteten Zustand den Ladekondensator CL mit einem Verschiebungspotential Vx verbindet, um die beabsichtigte Spannungsüberhöhung durch Potentialverschiebung der entsprechenden Kondensatorelektrode zu bewirken. Es ist möglich, daß sich das Verschiebungspotential Vx bei unterschiedlichen Werten der Versorgungsspannung U ebenso wie das Versorgungspotential VCC ändert.

Die mit der Grundschaltung 1 verbundene Zusatzschaltung 3 weist einen zweiten Transfertransistor T2 auf, welcher mittels des Aktivierungssignals Vakt parallel zum ersten Transfertransistor T1 schaltbar ist. Dazu ist der zweite Transfertransistor T2 über einen Schalter S2, der mittels des Aktivierungssignals Vakt steuerbar ist, mit dem Verschiebungspotential Vx verbunden. Der Schalter S2 kann beispielsweise als Transistor realisiert sein. Wird er geschlossen, ergibt sich eine kürzere Ladezeit des Ladekondensators CL, so daß die Spannungsüberhöhung der Boostspannung VBoost schneller erfolgt als bei deaktivierter Zusatzschaltung 3. Bei diesem Ausführungsbeispiel sind die beiden Transfertransistoren T1, T2 vom p-Kanal-Typ.

Bei dem in Figur 6 dargestellten Ausführungsbeispiel ist die Grundschaltung 1 eine aus dem Stand der Technik bekannte Eingangspufferschaltung. Sie weist zwischen einem höheren sechsten V6 und einem niedrigeren siebten V7 Potential einen CMOS-Inverter mit einem ersten p-Kanal-Transistor TP1 und einem n-Kanal-Transistor TN sowie einem als Konstantstromquelle wirkenden ersten Transistor T1 auf, welcher vom p-Kanal-Typ ist. Das siebte Potential V7 kann beispielsweise wiederum, wie dargestellt, Masse sein. Es wird angenommen, daß die Spannung zwischen dem sechsten Potential V6 und dem siebten Potential V7 abhängig vom Wert der Versorgungsspannung U ist. Die miteinander verbundenen Drains des ersten p-Kanal-Transistors TP1 und des n-Kanal-Transistors TN bilden den Ausgang der Eingangspufferschaltung, der gleichzeitig einer der Anschlüsse 4 ist. Der Eingang der Pufferschaltung (Gates des ersten p-Kanal-Transistors TP1 und des n-Kanal-Transistors TN) sowie das Gate des ersten Transistors T1 bilden je einen anderen der Anschlüsse 4.

Über einen Schalter S4, der mittels des Aktivierungssignals Vakt steuerbar ist und beispielsweise als Transistor realisiert sein kann (im Fall des Ausführungsbeispiels in Figur 6 kommt als Schalter S4 insbesondere ein p-Kanal-Transistor in Frage), ist ein zweiter Transistor T2, ebenfalls vom p-Kanal-Typ, der Bestandteil der mit der Grundschaltung 1 verbundenen Zusatzschaltung 3 ist, dem ersten Transistor T1 parallel schaltbar. Durch die Parallelschaltung des zweiten Transistors T2 ist es möglich, den Schaltpegel der Eingangspufferschaltung zu verändern und sie an die jeweils gültige Spezifikation beim Betrieb der integrierten Schaltung 10 mit verschiedenen Werten der Versorgungsspannung U anzupassen.

Eine Veränderung des Schaltpegels kann für das Ausführungsbeispiel der Grundschaltung 1 in Figur 6 auch erreicht werden, indem bei anderen Ausführungsformen der Erfindung der zweite Transistor T2 nicht parallel zum ersten Transistor T1, sondern parallel zum ersten p-Kanal-Transistor TP1 oder zum n-Kanal-Transistor TN schaltbar ist. Im letztgenannten Fall muß der zweite Transistor T2 vom n-Kanal-Typ sein.

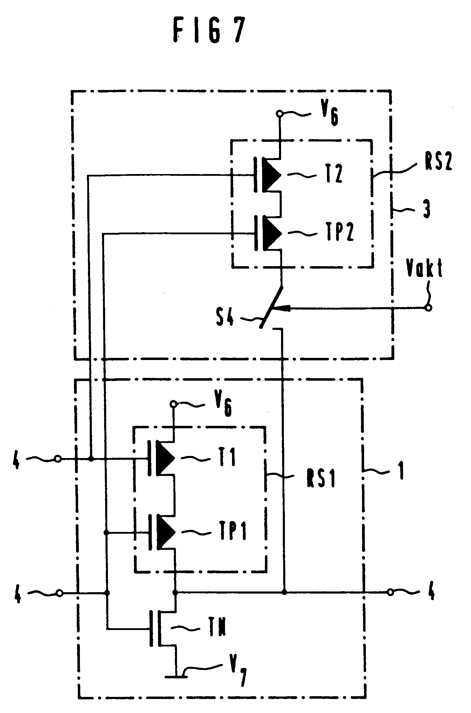

Beim Ausführungsbeispiel gemäß Figur 7 entspricht die Grundschaltung 1 der Eingangspufferschaltung aus Figur 6. Jedoch dient der Schalter S4 der Zusatzschaltung 3 diesmal zur Parallelschaltung einer zweiten Reihenschaltung RS2 zu einer ersten Reihenschaltung RS1. Die erste Reihenschaltung RS1 in Figur 7 ist Bestandteil der Grundschaltung 1 und weist den ersten Transistor T1 und den ersten p-Kanal-Transistor TP1 auf. Die zweite Reihenschaltung RS2 ist Bestandteil der Zusatzschaltung 3 und weist den zweiten Transistor T2 und einen zweiten p-Kanal-Transistor TP2 auf.

Bei allen bezüglich der Figuren 6 und 7 beschriebenen Ausführungsbeispiele ist es möglich, gezielt den Schaltpegel der Eingangspufferschaltung beziehungsweise Grundschaltung 1 durch Aktivierung der Zusatzschaltung 3 zu verändern, um ihn an den Betrieb mit einem anderen Wert der Versorgungsspannung U anzupassen.

Die Erfindung kann selbstverständlich auch auf andere als die hier beschriebenen Eingangspufferschaltungen angewendet werden. Diese müssen beispielsweise keine Konstantstromquelle aufweisen und können auch andere als CMOS-Inverter beinhalten.

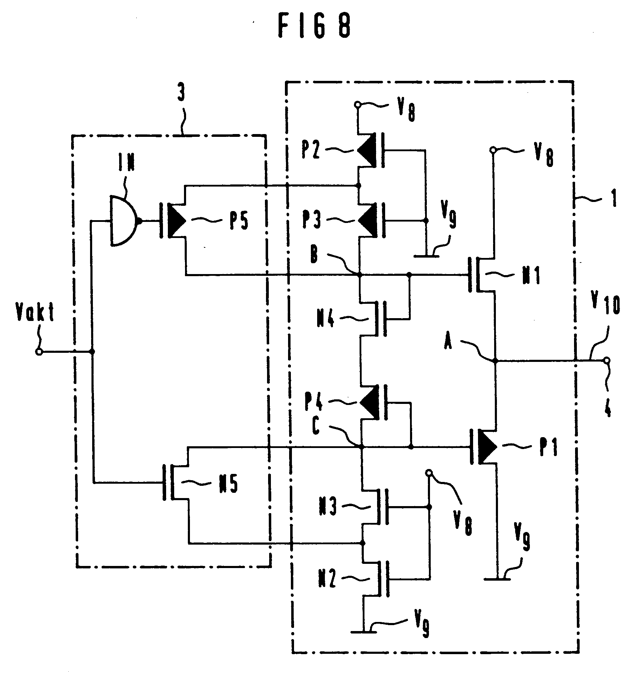

Figur 8 zeigt eine Grundschaltung 1, die zur Erzeugung eines zehnten Potentials V10 dient. Wie die Grundschaltung 1 in Figur 3 kann diejenige in Figur 8 beispielsweise als interner Spannungsgenerator der integrierten Schaltung 10 dienen. Dazu zählen u.a. Referenzspannungs-, Plattenspannungs-, Bitleitungsspannungs-, Substratvorspannungs- und Dummyzellenspannungsgeneratoren.

Die Grundschaltung 1 in Figur 8 weist zwischen einem achten Potential V8 und einem neunten Potential V9, welches, wie in Figur 8 dargestellt, beispielsweise Masse sein kann, eine Reihenschaltung eines ersten Transistors vom n-Kanal-Typ N1 und eines ersten Transistors vom p-Kanal-Typ P1 auf, welche in einem ersten Knotenpunkt A miteinander verbunden sind. Es wird unterstellt, daß die Spannung zwischen dem achten V8 und dem neunten V9 Potential sich in Abhängigkeit von der Versorgungsspannung U ändert. Der erste Knotenpunkt A ist mit einem der Anschlüsse 4 verbunden. An ihm entsteht das zehnte Potential V10. Sein Wert wird durch die Gate-Source-Spannungen des ersten Transisors vom n-Kanal-Typ N1 und des ersten Transistors vom p-Kanal-Typ P1 bestimmt. Das Gate des ersten Transistors vom n-Kanal-Typ N1 ist mit einem zweiten Knotenpunkt B verbunden, das Gate des ersten Transistors vom p-Kanal-Typ P1 mit einem dritten Knotenpunkt C.

Die Grundschaltung 1 beinhaltet weiterhin zwischen dem achten V8 und dem neunten V9 Potential eine Reihenschaltung eines zweiten P2 und eines dritten P3 Transistors vom p-Kanal-Typ, eines vierten Transistors vom n-Kanal-Typ N4, eines vierten Transistors vom p-Kanal-Typ P4 sowie eines dritten N3 und eines zweiten N2 Transistors vom n-Kanal-Typ. Die Gates des zweiten P2 und dritten P3 Transistors vom p-Kanal-Typ sind mit dem neunten Potential V9 und die Gates des zweiten N2 und dritten N3 Transistors vom n-Kanal-Typ mit dem achten Potential V8 verbunden. Außerdem sind jeweils Gate und Drain des vierten Transistors vom n-Kanal-Typ N4 und des vierten Transistors vom p-Kanal-Typ P4 miteinander verbunden. Der dritte Transistor vom p-Kanal-Typ P3 und der vierte Transistor vom n-Kanal-Typ N4 sind im zweiten Schaltungsknoten B miteinander verbunden. Der dritte Transistor vom n-Kanal-Typ N3 und der vierte Transistor vom p-Kanal-Typ P4 sind im Schaltungsknoten C miteinander verbunden.

Die Zusatzschaltung 3 in Figur 8 weist einen fünften Transistor vom p-Kanal-Typ P5, dessen Drain-Source-Strecke parallel zu derjenigen des dritten Transistors vom p-Kanal-Typ P3 geschaltet ist, und einen fünften Transistor vom n-Kanal-Typ N5, dessen Drain-Source-Strecke parallel zu derjenigen des dritten Transistors vom n-Kanal-Typ N3 geschaltet ist, auf. Das Gate des fünften Transistors vom n-Kanal-Typ N5 ist mit dem Aktivierungssignal Vakt verbunden. Das Aktivierungssignal Vakt ist außerdem über eine Invertierungsschaltung IN mit dem Gate des fünften Transistors vom p-Kanal-Typ P5 verbunden.

Mittels des Aktivierungsignals Vakt sind die Gate-Source-Spannungen des ersten Transistors vom n-Kanal-Typ N1 und des ersten Transistors vom p-Kanal-Typ P1 veränderbar.

## Patentansprüche

1. Integrierte Schaltung mit Grundschaltungen (1),
- wobei eine ordnungsgemäße Funktion der integrierten Schaltung (10) bei einem ersten Wert einer Versorgungsspannung (U) mittels der Grundschaltungen (1) gewährleistet ist,
- wobei die integrierte Schaltung (10) Zusatzschaltungen (3) aufweist, wobei jede Zusatzschaltung (3) mit wenigstens einer der Grundschaltungen (1) verbunden ist,
- wobei die Zusatzschaltungen (3) durch ein Aktivierungssignal (Vakt) aktivierbar und deaktivierbar sind,
- wobei die Zusatzschaltungen (3) im deaktivierten Zustand ohne Einfluß auf eine Funktion der Grundschaltungen (1) sind
- wobei die Zusatzschaltungen (3) im aktivierten Zustand die ordnungsgemäße Funktion der integrierten Schaltung (10) mittels der Grundschaltungen (1) bei einem zweiten Wert der Versorgungsspannung (U) bewirken,
**dadurch gekennzeichnet,**
daß eine der Grundschaltungen (1) einen ersten Transistor (T1) aufweist, der eine Konstantstromquelle ist, und daß die mit der Grundschaltung (1) verbundene Zusatzschaltung (3) einen zweiten Transistor (T2) vom gleichen Kanaltyp wie der erste Transistor (T1) aufweist, welcher mittels des Aktivierungssignals (Vakt) parallel zum ersten Transistor (T1) schaltbar ist.

2. Integrierte Schaltung nach Anspruch 1,
**dadurch gekennzeichnet,**
daß die Grundschaltung (1) eine erste Reihenschaltung (RS1) aus wenigstens dem ersten Transistor (T1) und einem ersten p-Kanal-Transistor (TP1) aufweist,
und daß die mit der Grundschaltung (1) verbundene Zusatzschaltung (3) eine zweite Reihenschaltung (RS2) aus wenigstens zwei Transistoren (T2, TP2) aufweist, welche mittels des Aktivierungssignals (Vakt) parallel zur ersten Reihenschaltung (RS1) schaltbar ist.

3. Integrierte Schaltung nach einem der vorstehenden Ansprüche,
**dadurch gekennzeichnet,**
daß ein Aktivierungssignal-Generator (9) vorgesehen ist, der an seinen Ausgang (6) das Aktivierungssignal (Vakt) gibt, welches in Abhängigkeit von einem Potential an einem Eingang (7) des Aktivierungssignal-Generators (9) zwei verschiedene Zustände annehmen kann,
und daß der Eingang (7) des Aktivierungssignal-Generators (9) über ein Verbindungselement (8) mit einem ersten Potential (V1) verbindbar ist.

4. Integrierte Schaltung nach Anspruch 3,
**dadurch gekennzeichnet,**
daß der Eingang (7) des Aktivierungssignal-Generators (9) mit seinem Ausgang (6) verbunden ist
und daß der Eingang (7) über ein erstes Widerstandselement (R1) mit einem zweiten Potential (V2) verbunden ist.

5. Integrierte Schaltung nach Anspruch 1 oder 2,
**dadurch gekennzeichnet,**
daß das Aktivierungssignal (Vakt) den Zusatzschaltungen (3) über einen externen Anschluß der integrierten Schaltung (10) zuführbar ist.
